# FASCICULE DE BREVET EUROPEEN

(11) **EP 1 518 279 B1**
(45) Date de publication et mention de la délivrance du brevet: **22.03.2006**
(21) Numéro de dépôt: 03762720.5
(22) Date de dépôt: 01.07.2003
(51) Int. Cl.: H01L 31/0203

(54) **DISPOSITIF DE MAINTIEN D UN OBJET SOUS VIDE ET PROCEDES DE F ABRICATION DE CE DISPOSITIF, APPLICATION AUX DETECTEURS INFRAROUGES NON REFROIDIS**
EINRICHTUNG ZUM HALTEN EINES OBJEKTS UNTER VAKUUM UND VERFAHREN ZU IHRER HERSTELLUNG UND BENUTZUNG IN NICHTGEKÜHLTEN INFRAROTSENSOREN
DEVICE FOR MAINTAINING AN OBJECT UNDER VACUUM AND METHODS FOR MAKING SAME, USE IN NON-COOLED INFRARED SENSORS

(30) Priorité: 03.07.2002 FR 0208293
(43) Date de publication de la demande: 30.03.2005
(73) Titulaire: COMMISSARIAT A L'ENERGIE ATOMIQUE, 75752 Paris Cédex 15 (FR)
(72) Inventeur: OUVRIER-BUFFET, Jean-Louis, F-74320 Sevrièr (FR); BISOTTO, Sylvette, F-38000 Grenoble (FR); Beccia, Chantal, F-38320 Eybens (FR)
(74) Mandataire: Poulin, Gérard
(86) Numéro de dépôt international: PCT/FR2003/002035
(87) Numéro de publication internationale: WO 2004/006290

(56) Documents cités:
- FR-A- 2 816 447
- US-A- 5 293 511
- US-A- 5 895 233
- US-A- 5 921 461
- PATENT ABSTRACTS OF JAPAN vol. 2000, no. 15, 6 avril 2001 (2001-04-06) -& JP 2000 337959 A (MITSUBISHI ELECTRIC CORP), 8 décembre 2000 (2000-12-08)

## Description

### DOMAINE TECHNIQUE

La présente invention concerne un dispositif de maintien d'un objet sous vide ainsi que des procédés de fabrication de ce dispositif.

Elle s'applique notamment au maintien sous vide d'un détecteur infrarouge non refroidi ou d'un ensemble de tels détecteurs.

Un détecteur infrarouge non refroidi comporte généralement un élément sensible qui peut être chauffé par un rayonnement infrarouge dans la bande II (3µm à 5µm) ou dans la bande III (8µm à 12µm), caractéristique de la température et de l'émissivité des corps observés. L'augmentation de la température de l'élément sensible engendre une variation d'une propriété électrique du matériau de cet élément sensible.

On observe par exemple l'apparition de charges électriques par effet pyroélectrique, ou une variation de capacité par changement de la constante diélectrique, ou encore une variation de la résistance du matériau qui peut être semi-conducteur ou métallique.

Un fonctionnement performant d'un détecteur infrarouge non refroidi nécessite que trois conditions principales soient satisfaites en ce qui concerne le matériau de l'élément sensible :
- ce dernier doit avoir une faible masse calorifique,
- une bonne isolation thermique doit exister entre la couche active de cet élément et le support de cette couche active, les deux premières conditions impliquant une utilisation de couches minces, et
- il doit exister une forte sensibilité de l'effet de conversion de l'échauffement en un signal électrique.

Des imageurs infrarouges monolithiques fonctionnant à température ambiante sont fabriqués en connectant directement une matrice d'éléments sensibles à un circuit de multiplexage en silicium de type CMOS ou CCD.

Un détecteur thermique peut être encapsulé sous vide ou sous un gaz peu conducteur de la chaleur pour augmenter les performances de ce détecteur. Le boîtier d'encapsulation comporte alors une fenêtre transparente dans la bande III.

L'opération d'intégration dans un boîtier, ou micro-boîtier, classique est délicate en ce qui concerne son rendement et, de plus, elle est relativement coûteuse. Aussi des techniques d'encapsulation collective ont-elles été proposées pour pallier ces difficultés.

Cependant, ces techniques présentent également des limitations qu'il convient de prendre en compte pour réduire les coûts et améliorer la durée de vie des micro-boîtiers d'encapsulation.

### ETAT DE LA TECHNIQUE ANTERIEURE

Dans le domaine de l'encapsulation collective sous vide de détecteurs infrarouges non refroidis, on cherche des techniques d'encapsulation permettant d'améliorer significativement le rendement d'intégration des détecteurs, tout en conservant un haut niveau de performance de ceux-ci et en réduisant leur coût.

On se reportera au document suivant :
[1] US 5 895 233A, Higashi et al., Integrated silicon vacuum micropackage for infrared devices.

Ce document divulgue l'encapsulation collective de dispositifs infrarouges (émetteurs ou détecteurs) par couplage d'une tranche ("wafer") de tels dispositifs avec une tranche de fenêtres transparentes au rayonnement infrarouge, afin de réaliser une micro-encapsulation sous vide ou sous un gaz peu conducteur de la chaleur.

Parmi les avantages potentiels de cette technique connue figurent le coût et l'encombrement réduit. En effet, ce dernier se limite typiquement à l'épaisseur de deux tranches de silicium.

La liaison entre les deux tranches est réalisée préférentiellement par un cordon, ou film, de soudure qui d'une part assure l'étanchéité et d'autre part détermine, selon son épaisseur, l'écartement entre les deux composants du micro-boîtier que l'on forme.

Le film de soudure résulte d'un dépôt sous vide, par la technique de pelage ("lift off"), ou d'une gravure après dépôt du matériau de soudure. Ce film peut provenir d'une préforme convenablement positionnée.

Pour maintenir une pression résiduelle acceptable à l'intérieur du micro-boîtier, il est nécessaire d'employer des matériaux dont le taux de dégazage n'est pas excessif.

Cependant, même avec un taux de dégazage relativement faible, il est utile, voire obligatoire, d'introduire un matériau getter dans le micro-boîtier pour adsorber les gaz émis par les différentes surfaces qui s'y trouvent car l'accroissement de la pression dégrade l'isolation thermique des micro-ponts que comportent les dispositifs encapsulés.

A cet effet, on propose, dans le document [1], d'introduire dans le micro-boîtier, sur le circuit détecteur ou émetteur ou sur les fenêtres, des films de baryum, de vanadium, de fer, de zirconium, ou d'alliages de ces matériaux.

Pour être rendus actifs, de tels matériaux doivent être portés à haute température pendant une courte période, soit par effet Joule soit par un faisceau laser, sans toutefois chauffer outre mesure les dispositifs détecteurs ou émetteurs ni les fenêtres.

Il est avantageusement suggéré de déposer un matériau getter, plus simplement appelé "getter", sur des micro-ponts réservés à cet usage, afin de confiner l'échauffement uniquement à ce matériau getter.

Cependant, l'emploi de getters pour obtenir le vide et assurer son maintien, vide qu'il convient également de confiner pour limiter l'éventuelle pollution des éléments sensibles tels que les micro-ponts, accroît la surface des puces ("chips") de détection (ou d'émission) au détriment du nombre de puces par tranche, et ce d'autant plus qu'il est difficile de les activer avec un bon rendement sans dépasser la température acceptable par le circuit de détection (ou d'émission), ce qui est donc compensé par un volume ou une surface de getter plus important.

Ainsi, dans la technique connue par le document [1], les getters utilisés prennent de la place et ne permettent pas une miniaturisation suffisante.

Typiquement, la longueur et la largeur des cavités, dont il est question dans le document [1], sont sensiblement égales et comprises entre quelques millimètres et quelques dizaines de millimètres, et la hauteur de ces cavités va de quelques micromètres à quelques centaines de micromètres selon le cas.

Ces petites dimensions ne permettent pas d'utiliser les moyens classiques d'incorporation du matériau getter (par exemple queusot en métal ou en verre, contenant ce matériau, ou filament de ce matériau placé dans le micro-boîtier et activé par effet Joule).

De plus, la technique divulguée par le document [1] est unitaire et coûteuse.

Le document JP 53 044 190 décrit un boitier pour récepteur de rayonnement infrarouge avec un système de refroidissement et un logement qui porte un getter destiné à piéger des gaz.

Les documents US-A-5 921 461, JP 2000 337959 et US-A-5 293 511 décrivent des boitiers étanches pour des dispositifs semi-conducteurs dans lesquels un getter est situé dans un logement formé à coté de la cavité.

### EXPOSÉ DE L'INVENTION

La présente invention a pour but de remédier aux inconvénients résultant de l'utilisation que l'on fait des getters dans cette technique du document [1].

L'invention permet d'intégrer, de manière collective, un matériau getter dans le procédé de fabrication de dispositifs de détection infrarouge non refroidis, de manière à réduire le coût de ces dispositifs.

L'invention consiste à placer le matériau getter en dessous du circuit de lecture associé aux détecteurs, ce qui ne fait pas perdre de place, et à relier ce matériau, par au moins un passage aussi petit que possible, à la cavité où le vide doit être maintenu.

L'utilisation de la face inactive du circuit de lecture, communément appelée "face arrière", permet de mettre en oeuvre un procédé de fabrication plus avantageux en termes de coût de production.

Plus généralement, la présente invention propose un dispositif et des procédés de fabrication de celui-ci, permettant de maintenir un objet sous vide dans une cavité sans encombrer cette dernière.

De façon précise, la présente invention concerne un dispositif de maintien d'un objet sous vide, ce dispositif comprenant une cavité étanche, qui contient l'objet et dans laquelle est fait le vide, cette cavité étant délimitée par un premier support, dont une première face forme le fond de la cavité, et par un deuxième support qui est fixé à cette première face de façon étanche, le dispositif comprenant en outre un getter destiné à pièger des gaz susceptibles de se trouver dans la cavité,
ce dispositif étant caractérisé en ce que le getter est placé à l'extérieur de la cavité et contenu dans un logement étanche qui est relié à cette cavité par au moins un passage étanche, ce passage étanche traversant le premier support, et en ce que le logement est formé dans le premier support, à partir de la deuxième face du premier support, opposée à la première face, et le passage étanche est formé à travers le premier support pour relier le logement à la cavité.

Selon un mode de réalisation particulier du dispositif objet de l'invention, la première face du premier support porte de l'objet.

Selon un autre mode de réalisation particulier, la première face du premier support porte l'objet, ce dernier étant un émetteur ou un récepteur de rayonnement infrarouge non refroidi ou un ensemble de tels émetteurs ou récepteurs, et le deuxième support est apte à laisser passer le rayonnement infrarouge.

De préférence, le logement est hermétiquement fermé par au moins une couche d'un matériau étanche.

Les parois du logement sont de préférence recouvertes d'au moins une couche de protection du premier support vis-à-vis du getter.

Cette couche de protection peut être faite d'un matériau choisi parmi SiO, SiN et Si₃N₄.

Le getter peut être fait à partir d'un matériau choisi parmi le titane, le molybdène, le baryum, le tantale, le zirconium, le fer et le vanadium.

La présente invention concerne aussi un procédé de fabrication du dispositif de l'invention, dans lequel
- on forme l'objet sur la première face du premier support,
- on forme le logement dans le premier support, à partir de la deuxième face de ce premier support,
- on forme le getter dans ce logement,
- on enferme hermétiquement le getter dans ce logement,
- on forme le passage à travers le premier support,
- on met sous vide l'ensemble ainsi obtenu,
- on fixe, de façon étanche, sous vide, le deuxième support à la première face du premier support, et
- on active le getter.

La présente invention concerne en outre un procédé de fabrication du dispositif de l'invention, dans lequel
- on forme l'objet sur la première face du premier support,
- on forme le logement dans le premier support, à partir de la deuxième face de ce premier support,
- on forme le getter dans ce logement,
- on forme le passage à travers le premier support,
- on fixe de façon étanche, sous une atmosphère quelconque, le deuxième support à la première face du premier support,
- on met sous vide l'ensemble ainsi obtenu, par pompage à travers le getter et le passage,
- on enferme hermétiquement le getter dans le logement, et
- on active le getter.

La présente invention concerne aussi un autre procédé de fabrication du dispositif de l'invention, dans lequel l'objet est un composant comprenant un émetteur ou un récepteur de rayonnement infrarouge non refroidi, ou une pluralité de tels composants, le deuxième support étant apte à laisser passer le rayonnement infrarouge, un circuit de lecture étant associé à ce composant ou à cette pluralité de tels composants et formé sur le premier support, et dans lequel
- on forme le logement dans le premier support, à partir de la deuxième face du premier support,
- on forme le circuit de lecture et l'on forme le getter dans le logement, pendant des étapes initiales de formation du circuit de lecture, ces étapes initiales supportant une haute température, mais avant des étapes finales de formation du circuit de lecture,
- on forme l'objet sur la première face du premier support,
- on enferme hermétiquement le getter dans le logement,
- on forme le passage à travers le premier support,
- on met sous vide l'ensemble ainsi obtenu,
- on fixe de façon étanche, sous vide, le deuxième support à la première face du premier support, et
- on active le getter.

La présente invention concerne en outre un autre procédé de fabrication du dispositif de l'invention, dans lequel l'objet est un composant comprenant un émetteur ou un récepteur de rayonnement infrarouge non refroidi, ou une pluralité de tels composants, le deuxième support étant apte à laisser passer le rayonnement infrarouge, un circuit de lecture étant associé à ce composant ou à cette pluralité de tels composants et formé sur le premier support, et dans lequel
- on forme le logement dans le premier support, à partir de la deuxième face du premier support,
- on forme le circuit de lecture et l'on forme le getter dans le logement, pendant des étapes initiales de formation du circuit de lecture, ces étapes initiales supportant une haute température, mais avant des étapes finales de formation du circuit de lecture,
- on forme l'objet sur la première face du premier support,
- on forme le passage à travers le premier support,
- on fixe de façon étanche, sous une atmosphère quelconque, le deuxième support à la première face du premier support,
- on met sous vide l'ensemble ainsi obtenu, par pompage à travers le getter et le passage,
- on enferme hermétiquement le getter dans le logement et
- on active le getter.

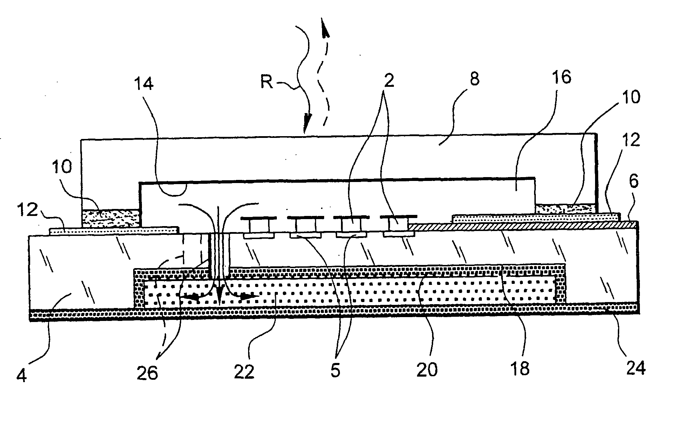

### BRÈVE DESCRIPTION DU DESSIN

La présente invention sera mieux comprise à la lecture de la description d'exemples de réalisation donnés ci-après, à titre purement indicatif et nullement limitatif, en faisant référence à la figure unique annexée qui est une vue en coupe schématique et partielle d'un mode de réalisation particulier du dispositif objet de l'invention.

### EXPOSÉ DÉTAILLÉ DE MODES DE RÉALISATION PARTICULIERS

Dans un exemple de l'invention, on veut maintenir sous vide un ensemble de composants constitués par des détecteurs ou des émetteurs infrarouges non refroidis, élaborés sur la face active d'un circuit de lecture.

Conformément à un mode de réalisation préféré de l'invention, on utilise la face opposée à cette face active du circuit de lecture pour implanter le matériau getter.

Un ou plusieurs orifices, qui sont en contact avec le matériau getter et débouchent dans la cavité où se trouve l'ensemble des composants, permettent de créer et/ou de maintenir le vide dans celle-ci.

Ce concept prolonge l'utilisation systématique des techniques de la microélectronique sur un semi-conducteur tel que le silicium, jusqu'à l'étape de création de la cavité.

La notion de cavité s'entend au sens large, puisque l'on peut aussi bien s'intéresser à l'encapsulation collective d'un dispositif constitué de détecteurs qu'à l'encapsulation individuelle de détecteurs disposés sous la forme d'une matrice.

Cette approche concerne toutes les dimensions de boîtier sous vide. Cependant, elle est particulièrement adaptée aux boîtiers de très faibles dimensions, dans lesquels il est difficile d'introduire puis d'activer un getter solide à proximité du dispositif à encapsuler, sans détériorer ce dispositif.

La figure unique annexée est une vue en coupe schématique d'un objet encapsulé sous vide conformément à l'invention.

Cet objet est un ensemble d'éléments émetteurs ou détecteurs de rayonnement 2, par exemple des microbolomètres.

Cet ensemble est formé sur une première face d'un substrat semi-conducteur 4 comportant le circuit de lecture 5 associé aux éléments. La vue en coupe est prise dans un plan perpendiculaire à ce circuit de lecture.

Cette première face, ou face avant, est pourvue de métallisations telles que la métallisation 6, permettant de relier électriquement le circuit de lecture à l'ensemble des composants.

En plus du substrat 4, le dispositif permettant de maintenir l'ensemble des éléments 2 sous vide comprend un autre substrat 8, ou fenêtre, apte à laisser passer le rayonnement R destiné à être détecté ou émis par les éléments ou composants 2. Ce substrat 8 est fixé de façon étanche au substrat 4, par l'intermédiaire d'un cordon de scellement 10.

Plus précisément, le substrat 4 comporte une couche électriquement isolante 12 qui s'étend sur la face avant du substrat 4, autour de l'ensemble des composants 2 et au-dessus des métallisations, et le cordon de scellement 10 s'appuie sur cette couche isolante 12, comme on le voit sur la figure annexée.

En outre, le substrat 8 comporte un évidement 14 qui, lorsque ce substrat 8 est scellé au substrat 4, définit une cavité 16 contenant les composants 2.

Du côté de sa face arrière (qui est opposée à sa face avant),le substrat 4 comporte un évidement 18 qui s'étend sensiblement sous toute la zone occupée par la cavité 16.

Un matériau getter 22 est placé dans l'évidement 18. Une ou plusieurs couches de barrière 20 recouvrent les parois de l'évidement 18 et servent à protéger le matériau constitutif du substrat 4 vis-à-vis du matériau getter 22.

Une ou plusieurs autres couches de barrière 24 sont formées sur la face arrière du substrat 8 pour enfermer de façon étanche ce matériau getter 22 dans la cavité qui est définie par l'évidement 18 et cette couche 24.

Conformément à l'invention, un ou plusieurs canaux 26 traversent le substrat 4 et la ou les couches de barrière 20 pour mettre en communication cette cavité et l'autre cavité 16, de manière à pouvoir maintenir le vide dans cette cavité 16 grâce au matériau getter.

Le fait de placer le matériau getter en dessous de la cavité 16 contenant les composants 2 permet un gain de place considérable.

On connaît divers procédés de fabrication de détecteurs ou émetteurs élémentaires de rayonnement infrarouge, tels que des microbolomètres par exemple, et il n'est pas nécessaire de les rappeler. I1 convient cependant de noter que le procédé de fabrication utilisé pour fabriquer les composants 2 n'est pas toujours compatible avec la technologie d'implantation et de mise en oeuvre du getter.

Rappelons qu'un getter, également appelé "fixateur de gaz", est un matériau poreux qui peut être transporté à l'air : une couche superficielle va se saturer et bloquer le phénomène de piégeage. Il suffit de chauffer ce matériau à une température spécifique pour que les impuretés piégées en surface diffusent vers le coeur du matériau pour rendre la surface à nouveau opérationnelle.

Dans l'invention, la surface du getter est calculée pour qu'elle puisse "absorber" toutes les impuretés susceptibles d'apparaître dans la cavité contenant le dispositif à maintenir sous vide (c'est à dire la cavité 16 contenant les composants 2 dans l'exemple représenté) au cours du fonctionnement de ce dispositif.

A la limite, si le getter venait quand même à être saturé, il suffirait de le réactiver par une nouvelle élévation adéquate de sa température pour obtenir un getter à nouveau efficace.

Un getter est élaboré à partir de matériaux qui, une fois activés, capturent les molécules de gaz résiduel. Ainsi, ils adsorbent, absorbent et/ou piègent les molécules de gaz émises par les parois de la cavité durant la vie du produit à maintenir sous vide.

Les matériaux getter préférés sont : le titane, le molybdène, le baryum, le tantale, le zirconium, le fer et le vanadium.

Ils se présentent le plus fréquemment sous la forme de poudres frittées ou de films réalisés par sérigraphie. L'élaboration de tels matériaux implique alors un recuit autour de 800°C dans un four à ultravide.

Ces matériaux peuvent être également déposés en couches minces par les techniques usuelles de la microélectronique, telles que l'évaporation et la pulvérisation.

Ces matériaux sont alors activés in situ car, une fois éjectés de la source ou de la cible dans le vide, ils ne rencontrent pas d'autres espèces sur leur parcours. Ils doivent donc être parfaitement encapsulés pour préserver leur efficacité de pompage après remise à l'air.

Le matériau getter 22 de la figure annexée est déposé dans la cavité correspondante par l'une des techniques mentionnées ci-dessus. Préalablement le matériau semi-conducteur du substrat 4 qui supporte le circuit de lecture est, comme on l'a vu, protégé par l'intermédiaire d'une ou de plusieurs couches-barrières par exemple constituées de SiO, SiN ou Si₃N₄.

Une fois déposé, et si cela est nécessaire, le matériau getter est planarisé par des techniques connues de l'homme du métier, telles qu'un polissage mécanique, mécanochimique ou électrochimique, avant ou après un recuit sous vide.

Finalement le matériau est encapsulé par une ou plusieurs couches-barrières afin de le protéger définitivement de l'atmosphère ambiante.

Selon son mode de fabrication, l'intégration du getter sur la face arrière du substrat portant le circuit de lecture est réalisée durant les phases de traitement de face avant ou de face arrière du procédé de fabrication de l'ensemble.

Le traitement de face arrière est constitué d'étapes technologiques qui peuvent se dérouler à de hautes températures, tandis que le traitement de face avant ne peut supporter et ne nécessite que des traitements thermiques qui ne dépassent pas 450°C et incluent, par exemple, la fabrication de détecteurs non refroidis.

Il est donc impératif d'introduire judicieusement les étapes d'intégration du getter dans le procédé de fabrication de l'ensemble afin d'obtenir des matériaux getter de grande qualité et de ne détériorer ni les composants 2 ni les circuits de lecture.

Un détecteur thermique encapsulé sous vide conformément à l'invention est constitué du micro-boîtier décrit précédemment (assemblage des substrats et du getter), conduisant à un composant optimisé en termes d'encombrement et de coût.

Les éléments de ce détecteur peuvent avoir une architecture matricielle, permettant de faire de l'imagerie infrarouge.

Dans un mode de réalisation préféré, un procédé de fabrication conforme à l'invention conserve un aspect collectif jusqu'au composant terminé, intégré dans un micro-boîtier sous vide.

Pour réaliser un assemblage collectif, on utilise deux substrats :
- une tranche ("wafer") de détecteurs infrarouges non refroidis sur un circuit de lecture en silicium, tranche au dos de laquelle est pratiqué un évidement qui est ensuite rempli d'un matériau getter, et
- une tranche de fenêtre pour rayonnement infrarouge (par exemple en Si, Ge ou ZnS).

Ces substrats sont préalablement élaborés séparément, en utilisant les techniques usuelles de la micro-électronique.

Ainsi les cavités dans la tranche de circuit de lecture et dans la tranche de fenêtre sont-elles formées par des procédés de gravure chimique ou de gravure par plasma. De même, le ou les orifices permettant l'évacuation des gaz résiduels vers le getter sont formés par de tels procédés.

A titre purement indicatif et nullement limitatif, l'épaisseur de la tranche de circuit de lecture se situe autour de 500µm, la profondeur des cavités se situe entre 5µm et 200µm et l'épaisseur de la tranche de fenêtre est comprise entre 100µm et 2mm selon sa nature et le format des détecteurs.

Les matériaux métalliques (tels que Ti, TiN, Pt, Al, Au, W, Ni, In, Sn, InPb, SnPb par exemple), qui constituent les plots métalliques d'interconnexion, les cordons de scellement et leur embases, sont déposés par pulvérisation cathodique, dépôt chimique en phase vapeur ("chemical vapour deposition") ou évaporation.

Ces diverses métallisations sont définies par des procédés de gravure chimique ou de gravure par plasma ou par un procédé de pelage ("lift off").

Les couches de matériaux, qui sont isolantes (couches de SiO, SiN ou Si₃N₄ par exemple) et/ou constituent une barrière pour la diffusion, sont obtenues par décomposition thermique (LPCVD) ou par décomposition par plasma (PECVD). L'épaisseur de ces couches est par exemple comprise entre 0,05µm et 5µm.

Pour obtenir N micro-boîtiers, une tranche portant N circuits de lecture et N ensembles de détecteurs élémentaires sur sa face avant et N cavités contenant du getter sur sa face arrière est scellée sous vide avec une tranche comportant N fenêtres, en utilisant la technique la plus appropriée.

Après ce scellement, la découpe est effectuée deux fois afin de séparer les N micro-boîtiers :
- une première fois pour séparer les N fenêtres et
- une deuxième fois pour séparer les N boîtiers.

L'activation du getter est effectuée in situ, lors du scellement, ou avant découpe ou après découpe, de façon qu'à l'issue de cette phase d'activation, le niveau de vide (pression résiduelle) dans la cavité soit inférieur ou égal à 1Pa.

Donnons encore des exemples de procédés conformes à l'invention, permettant la fabrication du dispositif de la figure annexée.

Dans un premier exemple,
- on forme les éléments 2 sur la face avant du substrat 4,
- on forme l'évidement 18 muni de la couche 20 dans le substrat 4, à partir de la face arrière de ce substrat 4,
- on forme le getter 22 dans cet évidement,
- on enferme hermétiquement le getter dans ce dernier par la couche 24,
- on forme le ou les canaux 26 à travers le substrat 4,
- on met sous vide l'ensemble ainsi obtenu,
- on scelle le substrat 8 à la face avant du substrat 4 et
- on active le getter.

Dans un deuxième exemple,
- on forme les éléments 2 sur la face avant du substrat 4,
- on forme l'évidement 18 muni de la couche 28 dans le substrat 4, à partir de la face arrière de ce substrat 4,
- on forme le getter 22 dans cet évidement,
- on forme le ou les canaux 26 à travers le substrat 4,
- on scelle le substrat 8 à la face avant du substrat 4 sous une atmosphère quelconque,
- on met sous vide l'ensemble ainsi obtenu par pompage à travers le getter 22,
- on enferme hermétiquement le getter dans son évidement par la couche 24, et
- on active le getter.

Dans un troisième exemple,
- on forme l'évidement 18 muni de la couche 20 dans le substrat 4, à partir de la face arrière du substrat 4,
- on forme le circuit de lecture 5 et l'on forme le getter 22 dans l'évidement pendant des étapes initiales de formation du circuit de lecture 5, ces étapes initiales supportant une haute température, mais avant des étapes finales (métallisation) de formation du circuit de lecture,
- on forme les éléments 2, sur la face avant du substrat 4,
- on enferme hermétiquement le getter dans l'évidement par la couche 24,
- on forme le ou les canaux 26 à travers le substrat 4,
- on met sous vide l'ensemble ainsi obtenu,
- on scelle le substrat 8 à la face avant du substrat 4 et
- on active le getter.

Dans un quatrième exemple,
- on forme l'évidement 18 muni de la couche 20 dans le substrat 4, à partir de la face arrière du substrat 4,
- on forme le circuit de lecture 5 et l'on forme le getter 22 dans l'évidement pendant des étapes initiales de formation du circuit de lecture 5, ces étapes initiales supportant une haute température, mais avant des étapes finales (métallisation) de formation du circuit de lecture,
- on forme les éléments 2, sur la face avant du substrat 4,
- on forme le ou les canaux 26 à travers le substrat 4,
- on scelle le substrat 8 à la face avant du substrat 4 sous une atmosphère quelconque,
- on met sous vide l'ensemble ainsi obtenu par pompage à travers le getter 22,
- on enferme hermétiquement le getter dans son évidement par la couche 24, et
- on active le getter.

Pour activer le getter hermétiquement enfermé dans sa cavité, on le chauffe à une température compatible avec les différents éléments du dispositif (circuit de lecture, composants, cordon de scellement ......).

La présente invention n'est pas limitée au maintien sous vide de détecteurs infrarouges non refroidis.

Tous les détecteurs de rayonnement ainsi que les capteurs mesurant des grandeurs physiques et les dispositifs qui doivent fonctionner sous un vide plus ou moins poussé peuvent profiter d'une encapsulation conforme à l'invention.

## Revendications

1. Dispositif de maintien d'un objet sous vide, ce dispositif comprenant une cavité étanche (16), qui contient l'objet (2) et dans laquelle est fait le vide, cette cavité étant délimitée par un premier support (4), dont une première face forme le fond de la cavité, et par un deuxième support (8) qui est fixé à cette première face de façon étanche, le dispositif comprenant en outre un getter (22) destiné à piéger des gaz susceptibles de se trouver dans la cavité,
ce dispositif étant **caractérisé en ce que** le getter (22) est placé à l'extérieur de la cavité (16) et contenu dans un logement étanche (18) qui est relié à cette cavité par au moins un passage étanche (26), ce passage étanche traversant le premier support, et **en ce que** le logement (18) est formé dans le premier support (4), à partir de la deuxième face du premier support (4), opposée à la première face, et le passage étanche (26) est formé à travers le premier support (4) pour relier le logement (18) à la cavitè (16).

2. Dispositif selon la revendication 1, dans lequel la première face du premier support (4) porte l'objet (2).

3. Dispositif selon la revendication 1, dans lequel la première face du premier support (4) porte l'objet (2), ce dernier étant un émetteur ou un récepteur de rayonnement infrarouge non refroidi, ou un ensemble de tels émetteurs ou récepteurs, et le deuxième support (8) est apte à laisser passer le rayonnement infrarouge (R).

4. Dispositif selon l'une quelconque des revendications 1 à 3, dans lequel le logement (18) est hermétiquement fermé par au moins une couche (24) d'un matériau étanche.

5. Dispositif selon l'une quelconque des revendications 1 à 4 dans lequel les parois du logement (18) sont recouvertes d'au moins une couche (20) de protection du premier support (4) vis-à-vis du getter (22).

6. Dispositif selon l'une quelconque des revendications 1 à 5, dans lequel cette couche de protection (20) est faite d'un matériau choisi parmi SiO, SiN et Si₃N₄.

7. Dispositif selon l'une quelconque des revendications 1 à 6, dans lequel le getter (22) est fait à partir d'un matériau choisi parmi le titane, le molybdène, le baryum, le tantale, le zirconium, le fer et le vanadium.

8. Procédé de fabrication du dispositif selon l'une quelconque des revendications 1 à 7, dans lequel
- on forme l'objet (2) sur la première face du premier support (4),
- on forme le logement (18) dans le premier support (4), à partir de la deuxième face de ce premier support (4),
- on forme le getter (22) dans ce logement,
- on enferme hermétiquement le getter dans ce logement,
- on forme le passage (26) à travers le premier support,
- on met sous vide l'ensemble ainsi obtenu,
- on fixe de façon étanche, sous vide, le deuxième support (8) à la première face du premier support, et
- on active le getter (22).

9. Procédé de fabrication du dispositif selon l'une quelconque des revendications 1 à 7, dans lequel
- on forme l'objet (2) sur la première face du premier support (4),
- on forme le logement (18) dans le premier support (4), à partir de la deuxième face de ce premier support (4),
- on forme le getter (22) dans ce logement,
- on forme le passage (26) à travers le premier support (4),
- on fixe de façon étanche, sous une atmosphère quelconque, le deuxième support (8) à la première face du premier support,
- on met sous vide l'ensemble ainsi obtenu, par pompage à travers le getter et le passage,
- on enferme hermétiquement le getter (22) dans le logement (18), et
- on active le getter (22).

10. Procédé selon la revendication 8, dans lequel l'objet est un composant comprenant un émetteur ou un récepteur de rayonnement infrarouge non refroidi, ou une pluralité de tels composants, le deuxième support (8) étant apte à laisser passer le rayonnement infrarouge (R), un circuit de lecture étant associé à ce composant ou à cette pluralité de tels composants et formé sur le premier support, et dans lequel
- on forme le circuit de lecture et l'on forme le getter (22) dans le logement, pendant des étapes initiales de formation du circuit de lecture, ces étapes initiales supportant une haute température, mais avant des étapes finales de formation du circuit de lecture,

11. Procédé selon la revendication 9, dans lequel l'objet est un composant comprenant un émetteur ou un récepteur de rayonnement infrarouge non refroidi, ou une pluralité de tels composants, le deuxième support (8) étant apte à laisser passer le rayonnement infrarouge (R), un circuit de lecture étant associé à ce composant ou à cette pluralité de tels composants et formé sur le premier support, et dans lequel
- on forme le circuit de lecture et l'on forme le getter (22) dans le logement (18), pendant des étapes initiales de formation du circuit de lecture, ces étapes initiales supportant une haute température, mais avant des étapes finales de formation du circuit de lecture.

## Patentansprüche

1. Vorrichtung zum Halten eines Objekts unter Vakuum, wobei diese Vorrichtung einen dichten Hohlraum (16) umfasst, der das Objekt (2) enthält und in dem das Vakuum hergestellt wird, und dieser Hohlraum abgegrenzt wird durch einen ersten Träger (4), von dem eine erste Seite bzw. Fläche den Boden des Hohlraums bildet, und einen zweiten Träger (8), der an dieser ersten Fläche bzw. Seite dicht befestigt ist, und die Vorrichtung dabei außerdem einen Getter (22) umfasst, der dazu dient, in dem Hohlraum befindliche Gase einzufangen, **dadurch gekennzeichnet, dass** sich der Getter (22) außerhalb des Hohlraums (16) befindet und in einem dichten Sitz (18) enthalten ist, der mit diesem Hohlraum durch wenigstens einen dichten, den ersten Träger durchquerenden Durchgang (26) verbunden ist, und **dadurch**, dass der Sitz (18) in dem ersten Träger (4) ausgebildet ist, der genannten ersten Seite entgegengesetzt, und der dichte Durchgang (26) den ersten Träger (4) durchquert, um den Sitz (18) mit dem Hohlraum (16) zu verbinden.

2. Vorrichtung nach Anspruch 1, bei der die erste Seite bzw. Fläche des ersten Trägers (4) das Objekt (2) trägt.

3. Vorrichtung nach Anspruch 1, bei der die erste Seite des ersten Trägers (4) das Objekt (2) trägt, wobei dieses ein ungekühlter Sender oder Empfänger von Infrarotstrahlung oder eine Gruppe solcher Sender oder Empfänger ist und der zweite Träger (8) die Infrarotstrahlung (R) durchlässt.

4. Vorrichtung nach einem der Ansprüche 1 bis 3, bei der der Sitz (18) hermetisch verschlossen ist durch wenigstens eine Schicht (24) aus dichtem Material.

5. Vorrichtung nach einem der Ansprüche 1 bis 4, bei der die Wände des Sitzes (18) überzogen sind mit wenigstens einer Schutzschicht (20) des ersten Trägers (4) gegenüber dem Getter (22).

6. Vorrichtung nach einem der Ansprüche 1 bis 5, bei der diese Schutzschicht (20) durch ein unter SiO, SiN und Si₃N₄ ausgewähltes Material gebildet wird.

7. Vorrichtung nach einem der Ansprüche 1 bis 6, bei der der Getter (22) durch ein unter Titan, Molybdän, Barium, Tantal, Zirkon, Eisen und Vanadium ausgewähltes Material gebildet wird.

8. Verfahren zur Herstellung der Vorrichtung nach einem der Ansprüche 1 bis 7, bei dem:
- man das Objekt (2) auf der ersten Fläche bzw. Seite des ersten Trägers (4) ausbildet,
- man den Sitz (18) in dem ersten Träger (4) ausbildet, auf der zweiten Seite bzw. Fläche dieses Trägers (4),
- man in diesem Sitz den Getter (22) bildet,
- man den Getter in diesem Sitz hermetisch einschließt,
- man den Durchgang (26) bildet, durch den ersten Träger hindurch,
- man in dem derart realisierten Aufbau Vakuum herstellt,
- man unter Vakuum den zweiten Träger (8) auf der ersten Seite bzw. Fläche des ersten Trägers dicht befestigt, und
- man den Getter (22) aktiviert.

9. Verfahren zur Herstellung der Vorrichtung nach einem der Ansprüche 1 bis 7, bei dem:
- man das Objekt (2) auf der ersten Seite des ersten Trägers (4) ausbildet,
- man den Sitz (18) im ersten Träger (4) ausbildet, auf der zweiten Seite dieses Trägers (4),
- man in diesem Sitz den Getter (22) bildet,
- man den Durchgang (26) bildet, durch den ersten Träger (4) hindurch,
- man unter einer beliebigen Atmosphäre den zweiten Träger (8) auf der ersten Seite bzw. Fläche des ersten Trägers dicht befestigt,
- man in dem derart realisierten Aufbau Vakuum herstellt, durch Pumpen durch den Getter und den Durchgang hindurch,
- man den Getter (22) in dem Sitz (18) hermetisch einschließt, und
- man den Getter (22) aktiviert.

10. Verfahren nach Anspruch 8, bei dem das Objekt ein einen ungekühlten Sender oder Empfänger von Infrarotstrahlung enthaltendes Bauteil oder eine Vielzahl solcher Bauteile umfasst, wobei der zweite Träger (8) die Infrarotstrahlung (R) durchlässt, und diesem Bauteil oder dieser Vielzahl von Bauteilen eine Leseschaltung zugeordnet und in dem ersten Träger ausgebildet ist, und bei dem man während Leseschaltungsbildungs-Anfangsschritten, die eine hohe Temperatur aushalten, aber vor Leseschaltungsbildungs-Endschritten in dem Sitz (18) den Getter (22) bildet.

11. Verfahren nach Anspruch 9, bei dem das Objekt ein einen ungekühlten Sender oder Empfänger von Infrarotstrahlung enthaltendes Bauteil oder eine Vielzahl solcher Bauteile umfasst, wobei der zweite Träger (8) die Infrarotstrahlung (R) durchlässt, und diesem Bauteil oder dieser Vielzahl von Bauteilen eine Leseschaltung zugeordnet und in dem ersten Träger ausgebildet ist, und bei dem man während Leseschaltungsbildungs-Anfangsschritten, die eine hohe Temperatur aushalten, aber vor Leseschaltungsbildungs-Endschritten in dem Sitz (18) den Getter (22) bildet.

## Claims

1. A device for holding an object under a vacuum, this device comprising a leak tight cavity (16) that contains the object (2) and in which the vacuum is created, this cavity being delimited by a first support (4), for which a first face forms the bottom of the cavity, and by a second support (8) that is fixed to this first face so as to be leak tight, the device also comprising a getter (22) designed to trap gases that could be located in the cavity,
this device being **characterized in that** the getter (22) is placed outside the cavity (16) and is contained in a leak tight housing (18) connected to this cavity through at least one leak tight passage (26), this leak tight passage passing through the first support and the housing (18) is formed in the first support (4) starting from the second face of said first support (4) opposite to the first face, and the tight passage (26) is formed through the first support (4) to connect the housing (18) to the cavity (16).

2. Device according to claim 1, in which the first face of the first support (4) carries the object (2).

3. Device according to claim 1, in which the first face of the first support (4) carries the object (2), the object being an uncooled infrared radiation emitter or receiver, or a set of such emitters or receivers, and the second support (8) is capable of allowing infrared radiation (R) to pass through.

4. Device according to any one of the claims 1 to 3, in which the housing (18) is hermetically sealed by at least one layer (24) of a leak tight material.

5. Device according to any one of the claims 1 to 4, in which the walls of the housing (18) are preferably covered by at least one layer (20) protecting the first support (4) from the getter (22).

6. Device according to any one of the claims 1 to 5, in which this protective layer (20) is made of a material chosen from among SiO, SiN and Si3N4.

7. Device according to any one of the claims 1 to 6, in which the getter (22) is made from a material chosen from among titanium, molybdenum, barium, tantalum, zirconium, iron and vanadium.

8. Process for making the device according to any one of the claims 1 to 7, in which:
- the object (2) is formed on the first face of the first support (4),
- the housing (18) is formed in the first support (4) starting from the second face of this first support (4),
- the getter (22) is formed in this housing,
- the getter is hermetically sealed in this housing,
- the passage (26) is formed through the first support,
- the assembly thus obtained is put under a vacuum,
- the second support (8) is fixed to the first face of the first support in a leak tight manner, under a vacuum, and
- the getter (22) is activated.

9. Process for making the device according to any one of the claims 1 to 7, in which:
- the object (2) is formed on the first face of the first support (4),
- the housing (18) is formed in the first support (4) starting from the second face of this first support (4),
- the getter (22) is formed in this housing,
- the passage (26) is formed through the first support (4),
- the second support (8) is fixed to the first face of the first support in a leak tight manner, under any type of atmosphere,
- the assembly thus obtained is put under a vacuum by pumping through the getter and the passage,
- the getter (22) is hermetically sealed in the housing (18), and
- the getter (22) is activated.

10. Process according to claim 8, in which the object is a component comprising an uncooled infrared radiation emitter or receiver, or a plurality of such components, the second support (8) allowing infrared radiation (R) to pass, a read circuit being associated with this component or with this plurality of such components and formed on the first support, and in which:
- the read circuit is formed and the getter (22) is formed in the housing during initial steps of formation of the read circuit, these initial steps resisting high temperatures, but before final steps for formation of the read circuit.

11. Process according to claim 9, in which the object is a component comprising an uncooled infrared radiation emitter or receiver, or a plurality of such components, the second support (8) allowing infrared radiation (R) to pass through, a read circuit being associated with this component or with this plurality of such components and formed on the first support, and in which:
- the read circuit is formed and the getter (22) is formed in the housing (18) during initial steps of formation of the read circuit, these initial steps resisting high temperatures, but before final steps for formation of the read circuit.
